# EUROPEAN PATENT APPLICATION

(11) **EP 4 610 760 A1**
(43) Date of publication of application: **03.09.2025**
(21) Application number: 25157968.6
(22) Date of filing: 14.02.2025
(51) Int. Cl.: G05B 23/02, G01R 31/00, B64D 45/00, F16H 55/08, H02P 9/42

(54) **REAL-TIME DIGITAL TWIN FOR AIRCRAFT-BASED INTEGRATED DRIVE GENERATOR**

(30) Priority: 16.02.2024 US 202418443495
(71) Applicant: ARINC Incorporated, Annapolis, MD 21401 (US)
(72) Inventor: ENSBERG, Joseph J., West Hartford, 06117 (US); HAUKOM, Michael J., Farmington, 55024 (US)
(74) Representative: Dehns

(57) **Abstract**

A system and method for digital twinning and monitoring of an aircraft-based integrated drive generator (IDG) or like rotational device provides decoded IDG signal values (e.g., a value for each voltage, load, frequency, or other signal generated by the IDG) to a set of machine learning (ML) models (e.g., one ML model for each IDG signal) trained on historical or simulated flight data. Each ML model infers a current nominal range for its corresponding IDG signal based on a subset of the decoded IDG signal values. Graphic representations of each decoded IDG signal value relative to the inferred nominal range of the corresponding IDG signal are generated for display via an aircraft display unit.

## Description

### BACKGROUND

Integrated drive generators (IDG) convert the variable-speed output of aircraft engine accessory drives to constant-speed output for use by aircraft electrical generators. IDG units are susceptible to component degradation and other failures which may result in delayed or cancelled flights. However, evaluation of IDG health is currently limited to off-wing analysis of full-flight data (and/or other data) sent to a centralized environment (e.g., on-premises, cloud) for post-flight processing, which precludes any proactive action being taken in the short term (e.g., within the next flight or two, in the case of many commercial aircraft).

### SUMMARY

In a first aspect, a system of microservices for digital twinning of an aircraft-based integrated drive generator (IDG) or like rotational device is disclosed. In embodiments, the systemincludes a subscriber module in communication with the IDG, the subscriber module providing a set of decoded IDG signal values, where each value corresponds to a signal generated by the IDG (e.g., based on alternating current (AC) load/voltage/frequency, oil inlet/outlet temperature, and/or other IDG parameters. The system includes a set of machine learning (ML) models, each ML model based on an IDG signal and trained on flight data to infer, based on a subset of the received set of IDG signal values, a nominal range for its corresponding IDG signal. The system includes a visualization module in communication with a display unit; the visualization module generates a graphic representation (for display by the display unit) of each decoded IDG signal value relative to its inferred nominal range.

In some embodiments, the subscriber receives encoded IDG signal data from the IDG (e.g., a generator control unit thereof) and decodes the IDG signal values for provision to the ML models.

In some embodiments, each ML model infers a nominal range for its corresponding IDG signal based on a set of IDG signal values excluding the signal value for that corresponding IDG signal (e.g., all other IDG signal values, but not the value for that IDG signal).

In some embodiments, the visualization module compares each decoded IDG signal value to its inferred nominal range. When, for example, the IDG deviates from the inferred nominal range, the visualization module generates an alert for display by the display unit.

In some embodiments, the graphic representation represents inferred nominal ranges in a first color, and any graphic alerts of deviation from the nominal ranges in a different color.

In some embodiments, the set of ML models is trained (e.g., fully, partially, selectively) on flight data specific to a particular IDG (e.g., corresponding to the serial number or other unique identifier of the aircraft-based IDG with which the system is in communication).

In some embodiments, the system is embodied in a ground-based device (e.g., at a ground control station) wirelessly linked to the IDG and to the display unit.

In some embodiments, the system is embodied in an aircraft data acquisition device (e.g., Aircraft Interface Device (AID)), edge compute device, or similar device permanently installed aboard the aircraft and physically linked to the IDG and to the display unit.

In some embodiments, the system is embodied in a portable processing device transportable aboard the aircraft, e.g., a laptop or tablet, and wirelessly linked to the IDG and to the display unit.

In a further aspect, a computer-assisted method for digital twinning of an integrated drive generator (IDG) or similar rotational device is also disclosed. In embodiments, the method includes providing a set of decoded IDG signal values, each value associated with an IDG signal (e.g., of a set of signals generated by the IDG). The method includes inferring, via a set of machine learning (ML) models, each ML model corresponding to a signal of the set of IDG signals, a current nominal range for its corresponding IDG signal based on the set of decoded IDG signal values. The method includes generating, for display by an aircraft-based display unit (e.g., to aircraft pilots/crew) a graphic representation of the decoded IDG signal values relative to their inferred nominal ranges.

In some embodiments, the method includes receiving (e.g., from a control unit of the IDG) encoded IDG signal data and decoding the received signal data into the set of IDG signal values.

In some embodiments, the method includes inferring, via each ML model corresponding to a particular IDG signal, a current nominal range for that IDG signal based on the full set of decoded IDG signal values but excluding the value corresponding to that IDG signal.

In some embodiments, the method includes comparing each decoded IDG signal value to its inferred nominal range. When the IDG signal value deviates from its nominal range, the method includes displaying (via the graphic representation) a graphic alert of the deviation.

In some embodiments, the method includes generating the graphic representations of the inferred nominal signal ranges in one color, and generating any alerts of deviation from the inferred nominal ranges in a different color.

In some embodiments, the set of ML models is trained (e.g., fully, partially, selectively) on flight data specific to a particular IDG (e.g., corresponding to the serial number or other unique identifier of the aircraft-based IDG with which the system is in communication).

In some embodiments, the system is embodied in a ground-based device (e.g., at a ground control station) wirelessly linked to the IDG and to the display unit.

In some embodiments, the system is embodied in an aircraft data acquisition device (e.g., Aircraft Interface Device (AID)), edge compute device, or similar device permanently installed aboard the aircraft and physically linked to the IDG and to the display unit.

In some embodiments, the system is embodied in a portable processing device transportable aboard the aircraft, e.g., a laptop or tablet, and wirelessly linked to the IDG and to the display unit.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a diagrammatic illustration of a system of microservices for digital twinning and real-time monitoring of integrated drive generator (IDG) signals according to example embodiments of this disclosure;
FIG. 2 is a block diagram of the system of microservices of FIG. 1;
FIG. 3 is an exemplary illustration of an IDG display generated by the system of microservices of FIG. 1; and
FIG. 4 is a flow diagram illustrating a method for real-time digital twinning and monitoring of an aircraft-based IDG according to example embodiments of this disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to a system and method for real-time digital twinning and data-driven monitoring of an aircraft-based integrated drive generator (IDG). For example, the system may be deployed on-wing or off-wing, and may notify end users of potential degradation and/or the need for responsive action in real time or near real time, allowing said responsive action (e.g., repair, replacement part requisition) to be taken without the undue delay associated with conventional IDG data analysis, reducing repair costs and the potential for secondary damage as a result of unaddressed degradation.

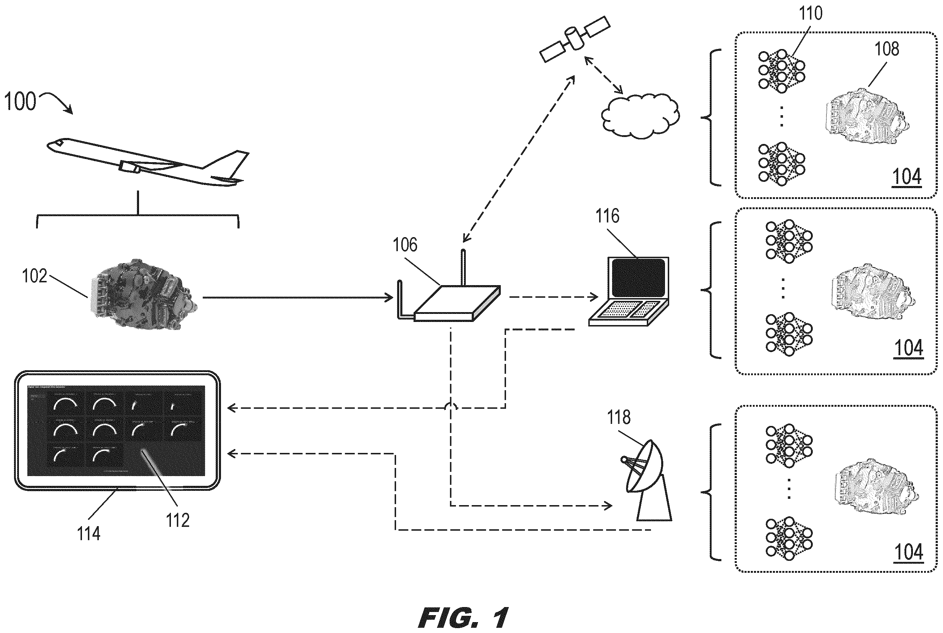

In embodiments, referring now to FIG. 1, the aircraft 100 may incorporate an IDG 102. For example, the IDG 102 may generate a set of signals corresponding to IDG parameters, e.g., alternating current (AC) frequency, AC load, AC voltage, oil inlet temperature, oil outlet temperature. The precise values of these various signals may vary inflight, e.g., based on the current flight segment, engine power levels, and other factors, but may be associated with nominal values or nominal ranges corresponding to specific conditions or combinations thereof. Deviation of IDG signal values from their nominal ranges may be indicative of potential or actual degradation of IDG components.

In embodiments, a system 104 of microservices configured for execution on one or more processors may retrieve encoded IDG signal data, e.g., from an aircraft data acquisition device 106 (ADAD; e.g., Aircraft Interface Device (AID)) or like avionics hardware onboard the aircraft 100. For example, the system 104 may decode the retrieved IDG signal data (e.g., from ARINC 429 or like data transfer protocol) into component signal values, each signal value based on an IDG parameter signal (e.g., a value of the signal at a particular time of validity). In some embodiments, the system 104 may retrieve previously decoded IDG signal data and pass the decoded IDG signal values for further processing (e.g., which may include converting the decoded IDG signal data into appropriate engineering units and/or other pre-processing).

In embodiments, the system 104 may include a digital twin 108 of the IDG 102, comprising a set of neural networks or like machine learning (ML) models 110, wherein each neural network/ML model corresponds to a specific IDG parameter signal and trained on historical IDG parameter data. For example, each ML model 110 may continually infer, based on the historical data on which it was trained and the decoded IDG signal values, a nominal range for its corresponding IDG signal.

In embodiments, the system 104 may generate, based on the decoded IDG signal values, as well as the corresponding nominal ranges for each IDG parameter signal (as inferred by the ML models 110 of the digital twin 108) a graphic representation 112 for display (e.g., to a pilot or operator of the aircraft 100) via a display unit 114. For example, the graphic representation 112 may depict a current value (e.g., for a given time of validity) of the associated IDG parameter signal relative to the coterminous inferred nominal range of the IDG parameter signal. The graphic representation 112 may show, at a glance, real-time performance of each IDG parameter signal relative to a baseline as defined by its current nominal range. Further, the system 104 may clearly highlight via the graphic representation 112 any deviation of an IDG signal value from its nominal range.

In embodiments, the system 104 may be embodied aboard the aircraft for on-wing digital twinning and monitoring of the IDG 102. For example, the system 104 may be embodied in a portable processing device 116, e.g., a laptop, tablet, or like device carried aboard the aircraft 100 and wirelessly linked to the IDG 102 and to the display unit 114. In some embodiments, the system 104 may be embodied in a ground-based device 118, e.g., a ground-based processing device wirelessly linked to the IDG 102 and to the display unit 114. In some embodiments, the system 104 may be embodied in a processing device permanently installed aboard the aircraft 100 and physically linked to the IDG 102 and display unit 114, e.g., within a certified edge compute device, or within an AID or other like aircraft data acquisition device 106.

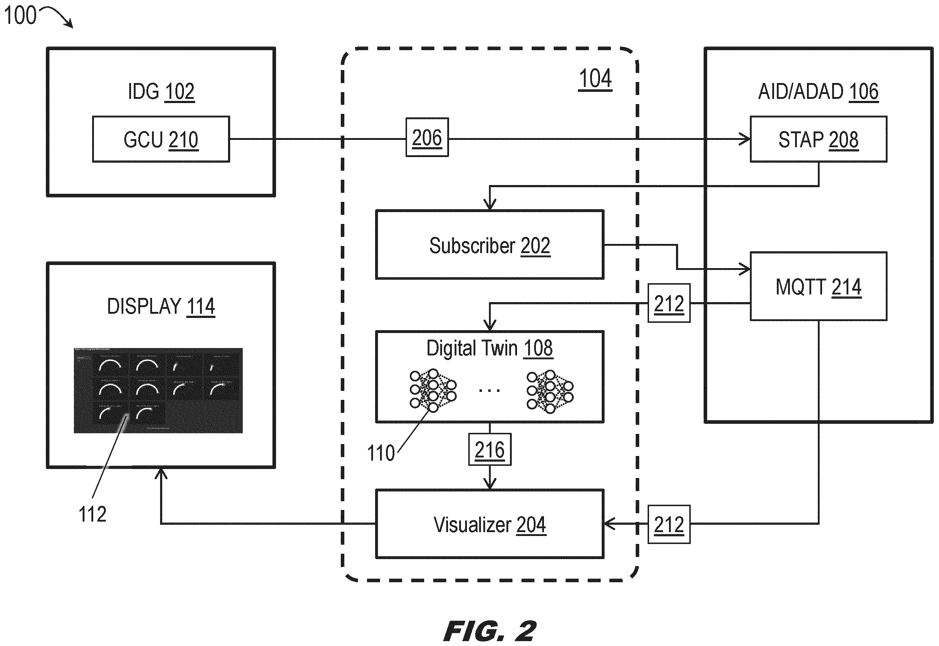

Referring to FIG. 2, the aircraft 100 is shown.

In embodiments, the system 104 may include a subscriber module 202, a digital twin 108 comprising a set of ML models 110, and a visualization module 204 configured to execute on one or more processors, e.g., within the portable processing device 116 (e.g., on-wing), the ground-based device 118 (e.g., off-wing), or the aircraft data acquisition device 106. For example, the subscriber module 202 may receive encoded IDG signal data 206 (e.g., in ARINC 429 or like data transfer format) provided to a Simple Text Avionics Protocol (STAP) server 208 within the aircraft data acquisition device 106 by a generator control unit 210 (GCU) within the IDG 102. Further, the subscriber module 202 may decode the received encoded IDG signal data, e.g., into IDG signal values 212 compatible with message queue telemetry transport (MQTT) or like protocol consistent with engineering units and consumable by the ML models 110. In some embodiments, the subscriber module 202 may retrieve previously decoded IDG signal values 212 (e.g., from an ARINC-to-MQTT decoder) and pass the decoded signal values to the digital twin 108 (which may additionally include conversion to engineering units, or other appropriate preprocessing, of the decoded IDG signal values).

In embodiments, each ML model 110 within the digital twin 108 may correspond to a specific IDG signal or parameter, e.g., AC frequency 1/AC frequency 2, AC load 1/AC load2, AC voltage 1/AC voltage 2, oil inlet temperature 1/oil inlet temperature 2, oil outlet temperature 1/oil outlet temperature 2. For example, the digital twin 108 may receive the decoded set of IDG signal values 212 (e.g., from the subscriber module 202, from the MQTT broker 214 within the aircraft data acquisition device 106).

In embodiments, each individual ML model 110 may be trained to infer a nominal range for its corresponding IDG signal value 212, e.g., what the value of the corresponding IDG signal value should be based on available data. For example, each ML model 110 may be trained according to, e.g., historical data based on IDG signals collected during previous flights, or simulated IDG data. Generally speaking, signal parameters associated with the IDG 102 may behave differently during different flight segments (e.g., taxi, takeoff, climb, cruise, descent, landing), and given a broad enough dataset that includes all normal operations of the IDG (and excludes known malfunctioning of IDG, for example) the digital twin 108 should predict a nominal range for any IDG signal parameter based on other current signal values obtained from the IDG.

In some embodiments, the set of ML models 110 may be trained, partially or fully, on flight data collected by the specific IDG 102 being monitored (e.g., corresponding to a serial number or other like unique unit identifier of the IDG aboard the aircraft 100). For example, the ML models 110 may be trained to infer nominal ranges for IDG signal values 212 based on the actual historical performance of the IDG 102, e.g., which may differ or deviate in subtle ways even from other IDG units of the same make, model, and aircraft implementation. In some embodiments, training of the ML models 110 may account for both unit-specific (e.g., tied to a particular IDG 102) and fleet-wide (e.g., tied to a set of IDG devices of like make, model, embodying aircraft) such that the precision of inferences made by each ML model may be adjustable.

In some embodiments, each ML model 110 may infer a nominal range 216 for its corresponding IDG signal value 212 based on the full subset of decoded IDG signal values, but excluding any IDG signal values based on the corresponding IDG signal. For example, an ML model 110 corresponding to the AC_FREQUENCY_1 signal may infer a current nominal range for the AC_FREQUENCY_1 signal based on decoded IDG signal values 212 associated with the AC_FREQUENCY_2, AC_LOAD_1, AC_LOAD_2, AC_VOLTAGE_1, AC_VOLTAGE_2, AC_OIL_INLET_TEMP_1, AC_OIL_INLET_TEMP_2, AC_OIL_OUTLET_TEMP_1, and AC_OIL_OUTLET_2 IDG signals, but exclude any values of the AC_FREQUENCY_1 signal. In embodiments, the nominal range 216 inferred by each ML model 110 for its corresponding IDG parameter signal may correspond to the same time of validity as the original encoded IDG signal data 206 received from the IDG 102.

In embodiments, the visualization module 204 may receive the decoded set of IDG signal values 212 as well as the set of nominal ranges 216 inferred by each ML model 110 for its corresponding IDG signal. For example, the visualization module 204 may generate a graphic representation 112 for display by the display unit 114, the graphic representation showing the decoded value 212 of each IDG parameter signal relative to the inferred nominal range 216 for that IDG parameter signal. In embodiments, the graphic representation 112 may depict each decoded IDG signal value 212 and its corresponding inferred nominal range 216 in a variety of formats, which may be selectable by the user of the display unit 114. Further, the graphic representation 112 may refresh in real time or near real time as new encoded IDG signal data 206 is output by the IDG 102 and received by the system 104.

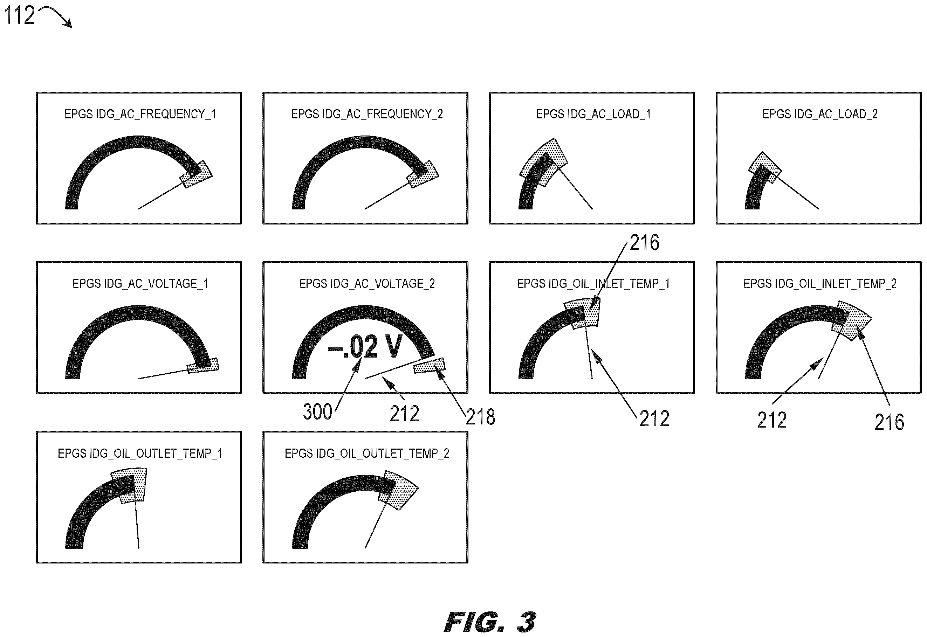

Referring now to FIG. 3, the graphic representation 112 displayed by the display unit (118, FIG. 1) is shown.

In embodiments, the graphic representation 112 may include, but is not limited to, a representation of each decoded IDG signal value 212 relative to its corresponding inferred nominal range 216 in the gauge format shown by FIG. 3. For example, the set of decoded IDG signal values 212 and inferred nominal ranges 216 may be shown in other formats, e.g., as selected by the user of the display unit. In some embodiments, the graphic representation 112 may include graphic equivalents of, e.g., the decoded IDG signal values 212 and/or scaling for the signal values and/or the inferred nominal range 216.

In embodiments, the system 104 may compare each decoded IDG signal value 212 to its corresponding inferred nominal range 216 to confirm that the IDG signal value is within the nominal range. For example, when one or more decoded IDG signal values 212 are outside the current inferred nominal range 216 for that IDG parameter signal (or, for example, deviates from the inferred nominal range by at least a threshold amount), the graphic representation 112 may include a deviation alert 300. The deviation alert 300 may include a numerical representation of the deviation of the decoded IDG signal value 212 from the inferred nominal range 216, e.g., -.02 V below the lower bound of the nominal range. In embodiments, the deviation alert 300 may be presented by the graphic representation 112 in a contrasting color to that of the inferred nominal range 216, e.g., to convey useful information about signal deviance (and potential component degradation) at a glance.

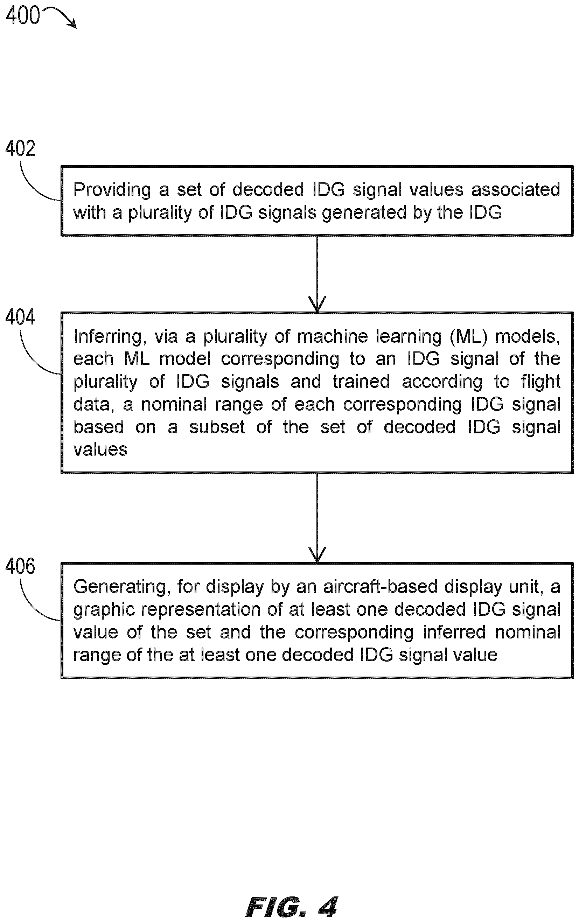

Referring now to FIG. 4, the method 400 may be implemented by the system 104 for digital twinning and real-time monitoring of an aircraft-based IDG and may include the following steps.

At a step 402, the system provides a set of decoded IDG signal values (e.g., to the set of ML models). For example, each decoded signal value may correspond to a specific IDG parameter signal, e.g., AC voltage, AC load, AC frequency, AC oil inlet temperature, AC oil outlet temperature. In some embodiments, the system retrieves previously decoded IDG signal values and passes these values along to the ML models. In some embodiments, the system decodes encoded IDG signal data generated by the IDG, providing the decoded IDG signal values to the ML models.

At a step 404, a set of machine learning (ML) models (e.g., feed forward neural networks) trained on IDG parameter signal data infers a nominal range for each IDG parameter signal, based on a subset of the set of decoded IDG signal values. For example, the set may include an ML model specific to each IDG parameter signal and trained to infer a current nominal range for that signal. In some embodiments, each ML model may infer a range for its corresponding signal based on a subset of decoded IDG signal values that excludes any values of the corresponding IDG parameter signal. In some embodiments, one or more of the ML models is trained on historical IDG data specific to the IDG being monitored (e.g., tied to the specific serial number or unique unit identifier of that particular IDG as opposed to, or in addition to, fleet-wide historical data collected from a group of like IDGs sharing a make, model, embodying aircraft, and/or other similarities).

At a step 406, the system generates a graphic representation of each decoded IDG signal value and its inferred nominal range for display by an aircraft-based display unit. For example, the graphic representation may refresh in real time or near real time as new encoded IDG signal data is received, decoded, and processed by the system. The system may compare each decoded IDG signal value to its corresponding nominal range; when the signal value sufficiently deviates from the nominal range (e.g., to a threshold level, or merely outside the nominal range), the graphic representation includes a graphic alert of the deviation. For example, with respect to a particular IDG parameter signal, the current nominal range is displayed in a first color while the graphic alert is displayed in a contrasting color. In some embodiments, the graphic alert includes a numerical value of the deviation of the decoded IDG signal value above or below the nominal range.

### CONCLUSION

It is to be understood that embodiments of the methods disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

Although inventive concepts have been described with reference to the embodiments illustrated in the attached drawing figures, equivalents may be employed and substitutions made herein without departing from the scope of the claims. Components illustrated and described herein are merely examples of a system/device and components that may be used to implement embodiments of the inventive concepts and may be replaced with other devices and components without departing from the scope of the claims. Furthermore, any dimensions, degrees, and/or numerical ranges provided herein are to be understood as non-limiting examples unless otherwise specified in the claims.

## Claims

1. A system of microservices for digital twinning of an aircraft-based Integrated Drive Generator "IDG", the system comprising:
a subscriber module (204) communicatively coupled to an IDG of an aircraft, the subscriber module configured to provide a set of IDG signal values based on encoded IDG signal data corresponding to a plurality of IDG signals;
a plurality of machine learning "ML" models (110), each ML model corresponding to an IDG signal of the plurality of IDG signals and trained according to flight data to infer, based on a subset of the set of IDG signal values, a nominal range of the corresponding IDG signal, each nominal range associated with the time of validity;
and
a visualization module (204) communicatively coupled to a display unit of the aircraft, the visualization module configured to:
receive the set of IDG signal values from the subscriber module;
receive the set of inferred nominal ranges from the plurality of ML models;
and
generate for display by the display unit at least one graphic representation of at least one IDG signal value of the set and its corresponding inferred nominal range.

2. The system of Claim 1, wherein the subscriber module is configured to:
receive encoded IDG signal data from the IDG, the encoded IDG signal data corresponding to the plurality of IDG signals;
determine the set of IDG signal values decoding the encoded IDG signal data;
and
provide the decoded set of IDG signal values to the plurality of ML models.

3. The system of any preceding Claim, wherein each ML model is trained to infer the nominal range of the corresponding IDG signal based on the set of IDG signal values excluding the IDG signal value of the corresponding IDG signal.

4. The system of any preceding Claim, wherein the visualization module is configured to:
compare each IDG signal value and its corresponding inferred nominal range;
and
when the IDG signal value deviates from the corresponding inferred nominal range, generate for display by the display unit a graphic alert corresponding to the deviation, and optionally wherein:
the graphic representation represents the set of inferred nominal ranges in a first color;
and
the graphic representation represents the graphic alert in a second color contrasting with the first color.

5. The system of any preceding Claim, wherein:
the IDG corresponds to a unique unit identifier;
and
the plurality of ML models is trained according to flight data corresponding to the unique unit identifier.

6. The system of any preceding Claim, wherein:
the system is embodied in a ground-based device wirelessly linked to the IDG and to the display unit.

7. The system of any preceding Claim, wherein:
the system is embodied in a processing device permanently installed aboard the aircraft and physically linked to the IDG and to the display unit.

8. The system of any preceding Claim, wherein:
the system is embodied in a portable processing device capable of being transported by the aircraft, the portable processing device wirelessly linked to the IDG and to the display unit.

9. A computer-assisted method for digital twinning of an aircraft-based integrated drive generator "IDG", the method comprising:
providing a set of decoded IDG signal values associated with a plurality of IDG signals generated by the IDG;
inferring, via a plurality of machine learning (ML) models, each ML model corresponding to an IDG signal of the plurality of IDG signals and trained according to flight data, a nominal range of each corresponding IDG signal based on a subset of the set of decoded IDG signal values;
and
generating, for display by an aircraft-based display unit, a graphic representation of at least one decoded IDG signal value of the set and the corresponding inferred nominal range of the at least one decoded IDG signal value.

10. The computer-assisted method of Claim 9, wherein providing a decoded set of IDG signal values associated with a plurality of IDG signals generated by the IDG includes:
receiving, from the IDG, a set of encoded IDG signal data corresponding to the plurality of IDG signals;
and
providing the set of IDG signal values by decoding the set of encoded IDG signal data.

11. The computer-assisted method of Claim 9 or 10, wherein inferring, via a plurality of ML models, each ML model corresponding to an IDG signal of the plurality of IDG signals, a nominal range of each corresponding IDG signal based on a subset of the set of decoded IDG signal values, includes:
inferring, via at least one ML model corresponding to an IDG signal of the plurality of IDG signals, a nominal range of the corresponding IDG signal based on the set of decoded IDG signal values excluding the decoded IDG signal value of the corresponding IDG signal.

12. The computer-assisted method of any of Claims 9 to 11, wherein generating, for display by an aircraft-based display unit, a graphic representation of at least one decoded IDG signal value of the set and the corresponding inferred nominal range of the at least one decoded IDG signal value includes:
comparing each decoded IDG signal value to its corresponding inferred nominal range;
and
when the decoded IDG signal value deviates from the corresponding inferred nominal range, generating for display by the display unit a graphic alert corresponding to the deviation, and optionally
wherein:
generating, for display by an aircraft-based display unit, a graphic representation of at least one decoded IDG signal value of the set and the corresponding inferred nominal range of the at least one decoded IDG signal value includes:
generating the graphic representation of the corresponding inferred nominal range in a first color;
and
wherein generating for display by the display unit a graphic alert corresponding to the deviation includes:
generating the graphic alert in a second color contrasting with the first color.

13. The computer-assisted method of any of Claims 9 to 12, wherein:
receiving a set of encoded IDG signal data corresponding to a plurality of IDG signals includes:
receiving a set of encoded IDG signal data from an IDG having a unique unit identifier;
and
wherein inferring, via a plurality of machine learning models, each ML model corresponding to an IDG signal of the plurality of IDG signals and trained according to flight data, a nominal range of each corresponding IDG signal based on a subset of the set of decoded IDG signal values includes:
inferring, via a plurality of ML models, each ML model trained according to flight data specific to the unique unit identifier of the IDG, a nominal range of each corresponding IDG signal based on a subset of the set of decoded IDG signal values.

14. The computer-assisted method of any of Claims 9 to 13, wherein the method is implemented via a ground-based device wirelessly linked to the IDG and to the display unit.

15. The computer-assisted method of any of Claims 9 to 14, wherein the method is implemented via a processing device permanently installed aboard the aircraft, the processing device physically linked to the IDG and to the display unit, or wherein the method is implemented via a portable processing device capable of being transported by the aircraft, the portable processing device wirelessly linked to the IDG and to the display unit.
